# FASCICULE DE BREVET EUROPEEN

(11) **EP 2 368 128 B1**
(45) Date de publication et mention de la délivrance du brevet: **19.02.2014**
(21) Numéro de dépôt: 09793551.4
(22) Date de dépôt: 21.12.2009
(51) Int. Cl.: G01R 31/12, H01L 31/042

(54) **PROCEDE DE DETECTION D'ARC ELECTRIQUE DANS UNE INSTALLATION PHOTOVOLTAIQUE**
VERFAHREN ZUM DETEKTIEREN EINES ELEKTRISCHEN BOGENS IN FOTOVOLTAIKGERÄTEN
METHOD FOR DETECTING AN ELECTRIC ARC IN PHOTOVOLTAIC EQUIPMENT

(30) Priorité: 22.12.2008 FR 0807432
(43) Date de publication de la demande: 28.09.2011
(73) Titulaire: Commissariat à l'Énergie Atomique et aux Énergies Alternatives, 75015 Paris (FR)
(72) Inventeur: CHAINTREUIL, Nicolas, 73800 MONTMELIAN (FR); PERICHON, Pierre, F-38500 Voiron (FR); VALLET, Sandrine, F-73230 Barby (FR)
(74) Mandataire: Novaimo
(86) Numéro de dépôt international: PCT/EP2009/067650
(87) Numéro de publication internationale: WO 2010/072717

(56) Documents cités:
- WO-A-00/79604
- WO-A1-95/25374
- DE-A1- 3 816 047
- FR-A- 2 761 541
- FR-A- 2 827 675
- JP-A- 1 163 809
- US-A1- 2008 147 335

## Description

L'invention concerne un procédé de détection d'un arc électrique dans un système photovoltaïque ainsi qu'un procédé de gestion sécurisée d'un système photovoltaïque. Elle concerne aussi un module photovoltaïque et un dispositif photovoltaïque équipés d'un dispositif de sécurité contre l'apparition d'arcs électriques.

Les installations photovoltaïques fonctionnent à tension continue et courant continu importants, ce qui engendre des risques d'apparition d'arcs électriques. De tels arcs électriques peuvent survenir suite à une erreur de manipulation, par exemple si un opérateur ouvre malencontreusement un connecteur en charge, ou suite à la dégradation des connexions de l'installation. Ces arcs électriques génèrent une forte chaleur de plasma pendant une durée importante puisque sous tension continue, la valeur de la tension n'est jamais nulle au contraire d'un système alternatif, et sont de ce fait très dangereux pour les personnes et les installations. De plus, l'intégration des modules photovoltaïques dans la toiture des bâtiments risque de déclencher l'incendie des charpentes en cas d'arc électrique.

Les installations photovoltaïques peuvent être reliées au réseau électrique par l'intermédiaire d'un onduleur. Dans une telle configuration, il existe des systèmes de sécurité permettant de détecter un éventuel arc électrique survenant sur la liaisons électrique entre un champ de modules photovoltaïques et l'onduleur. IP 01/63 809 divulgue un tel système. Toutefois, ces systèmes sont insuffisants puisqu'un tel arc électrique est susceptible de se produire au niveau d'un module photovoltaïque lui-même. US 2008/0147335 divulgue un système de détection d'arc électrique au niveau d'un module photovoltaïque.

Il est connu du document FR2827675 la possibilité de détecter un arc électrique au sein d'un conducteur électrique rigide par l'ajout d'un capteur à ultrasons positionné sur ce conducteur pour mesurer l'onde sonore induite par l'arc électrique sur ce conducteur. Cette solution est adaptée à un conducteur métallique rigide d'un circuit électrique particulier et conventionnel. DE 3816047 divulgue un dispositif de détection, par des ondes acoustic, des arcs électriques dans un appareil isolé au gas ou d'isolant solid. Un module photovoltaïque comprend une structure très particulière confinée dans des matériaux protecteurs de type verre, dans laquelle les ondes de type ultrasons ne se comportent pas du tout comme dans le cas d'un simple conducteur en cuivre. De plus, un module photovoltaïque est en général positionné dans des environnements extérieurs agressifs, subissant toutes les contraintes climatiques, vent, pluie, froid, chaud. Pour toutes ces raisons, les solutions traditionnelles appliquées aux conducteurs électriques en cuivre ne sont pas applicables au domaine très spécifique et éloigné des installations photovoltaïques.

Un problème technique supplémentaire se pose suite à un incident électrique de type arc électrique survenu dans une installation photovoltaïque, qui consiste à optimiser les opérations de maintenance et de réparation qui peuvent facilement s'avérer fastidieuses du fait du nombre élevé de modules équivalents et du fait de leur positionnement pas toujours facilement accessible dans une telle installation.

Ainsi, un objet général de l'invention est de proposer une solution de détection d'un arc électrique dans une installation photovoltaïque, afin d'améliorer la sécurité de telles installations.

Plus précisément, l'invention cherche à atteindre tout ou partie des objets suivants :

Un premier objet de l'invention est de proposer une solution permettant de détecter un arc électrique survenant au sein même d'un module photovoltaïque.

Un second objet de l'invention est de proposer une solution permettant de sécuriser une installation photovoltaïque dans laquelle survient un arc électrique, notamment en intervenant très rapidement en cas de détection d'un arc électrique.

Un troisième objet de l'invention est de proposer une solution permettant de faciliter la maintenance et la réparation d'une installation photovoltaïque ayant subi un arc électrique.

A cet effet, l'invention repose sur un procédé de détection par ultrasons d'un arc électrique dans un dispositif photovoltaïque, caractérisé en ce qu'il comprend les étapes suivantes :
- Positionnement d'un capteur à ultrasons (6 ; 16) sur un module photovoltaïque (2 ; 12) ou sur un châssis (3 ; 13) supportant plusieurs modules photovoltaïques (2 ; 12) ;
- Mesure d'au moins un paramètre d'un signal reçu par un capteur à ultrasons parmi l'amplitude du signal, la durée du signal, la fréquence centrale du signal ;
- Comparaison de la mesure de ce au moins un paramètre du signal avec des valeurs prédéfinies pour déterminer si la mesure correspond à celle d'un arc électrique.

L'étape de comparaison de la mesure du au moins un paramètre avec des valeurs prédéfinies comprend les vérifications suivantes permettant de déterminer que le signal est bien généré par un arc électrique :
- vérification si l'amplitude du signal reçu est supérieure ou égale à 40 dB ; et/ou
- vérification si la durée du signal reçu est comprise entre 15 et 25 µs ; et/ou
- vérification si la fréquence centrale du signal reçu est comprise entre 200 et 360 kHz.

Le procédé de détection par ultrasons d'un arc électrique peut en outre comprendre l'étape supplémentaire suivante permettant de déterminer que le signal est bien généré par un arc électrique :
- vérification si la tension efficace du signal enregistré augmente, d'une première valeur comprise entre 5 et 15 dB_{EA}, vers une seconde valeur comprise entre 15 et 25 dB_{EA}.

L'invention porte aussi sur un procédé de gestion sécurisée d'un dispositif photovoltaïque, caractérisé en ce qu'il comprend un procédé de détection par ultrasons d'un arc électrique tel que décrit précédemment, puis en ce qu'il comprend une étape consistant à ouvrir le circuit électrique du dispositif photovoltaïque en cas de détection d'un arc électrique, afin d'éteindre l'arc électrique.

Le procédé peut mettre en oeuvre les étapes supplémentaires suivantes :
- après ouverture du circuit électrique suite à la détection d'un arc électrique, remise en fonctionnement du dispositif photovoltaïque au moins une fois ;
- s'il y a de nouveau la détection d'un arc électrique, arrêt du fonctionnement du dispositif photovoltaïque et transmission d'information de la défaillance du dispositif photovoltaïque.

Le procédé de gestion peut comprendre une étape supplémentaire de localisation de l'arc électrique dans le dispositif photovoltaïque.

Cette étape de localisation de l'arc électrique dans le dispositif photovoltaïque peut comprendre les sous-étapes suivantes :
- mémorisation des temps de réception du signal pour chacun des capteurs et classement de ces capteurs dans l'ordre de réception ;
- détermination en fonction de l'ordre d'arrivée du signal sur chaque capteur de la localisation de l'arc électrique.

De plus, le procédé de gestion sécurisée d'un dispositif photovoltaïque peut comprendre une étape préliminaire de déclenchement du procédé de détection d'arc électrique qu'à partir du moment où le dispositif photovoltaïque dépasse un certain seuil de production électrique.

L'invention porte aussi sur un module photovoltaïque caractérisé en ce qu'il comprend un capteur à ultrasons pour la détection des arcs électriques et un moyen de communication de ce capteur à ultrasons vers une unité de traitement.

Le capteur à ultrasons pour la détection des arcs électriques se trouve sur le cadre ou sur le verre du module.

Enfin, l'invention porte aussi sur un dispositif photovoltaïque comprenant des modules photovoltaïques montés sur un ou plusieurs châssis, caractérisé en ce qu'il comprend au moins un capteur à ultrasons pour la détection des arcs électriques positionné sur un module photovoltaïque ou sur un châssis supportant plusieurs modules photovoltaïques et en ce qu'il comprend une unité de traitement mettant en oeuvre le procédé de détection des arcs électriques décrit précédemment.

Le dispositif photovoltaïque peut comprendre au moins un capteur à ultrasons pour deux modules photovoltaïques.

Le dispositif photovoltaïque peut comprendre un dispositif de sécurité dont la fonction est d'ouvrir le circuit électrique en cas de détection d'arc électrique, le dispositif photovoltaïque mettant en oeuvre le procédé de gestion sécurisée tel que décrit précédemment.

Le dispositif de sécurité peut être positionné sur une borne de sortie du champ de modules photovoltaïques du dispositif photovoltaïque ou directement au niveau de tout ou partie des modules photovoltaïques.

Ces objets, caractéristiques et avantages de la présente invention seront exposés en détail dans la description suivante d'un mode d'exécution particulier fait à titre non-limitatif en relation avec les figures jointes parmi lesquelles :
La figure 1 illustre schématiquement un dispositif photovoltaïque selon un mode d'exécution de l'invention.
La figure 2 représente une onde acoustique générée dans le dispositif photovoltaïque par un arc électrique.
La figure 3 représente une onde acoustique générée dans le dispositif photovoltaïque par la dilatation thermique d'un module photovoltaïque.
La figure 4 illustre schématiquement un dispositif photovoltaïque selon une variante d'exécution de l'invention.
La figure 5 reprend le schéma précédent pour illustrer la mise en oeuvre d'une étape du procédé de gestion sécurisée du dispositif photovoltaïque selon un mode d'exécution de l'invention.

L'invention repose sur l'analyse du signal à ultrasons émis par un arc électrique au sein du milieu confiné représenté par un module photovoltaïque et un champ de modules photovoltaïques, de sorte à détecter et identifier la signature acoustique d'un arc électrique. Le concept de l'invention consiste donc à utiliser un ou plusieurs capteur(s) à ultrasons positionné au niveau d'un module photovoltaïque, puis à définir un traitement particulier des mesures effectuées par ce(s) capteur(s) pour identifier avec précision l'existence ou non d'un arc électrique au sein d'une installation photovoltaïque.

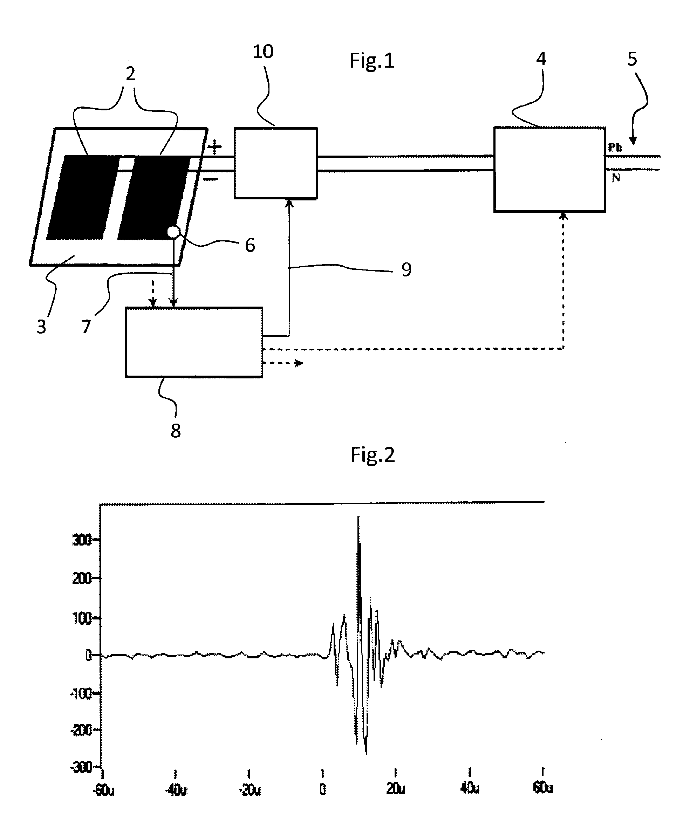

La figure 1 représente schématiquement un dispositif photovoltaïque selon un mode d'exécution de l'invention. Ce dispositif comprend deux modules photovoltaïques 2 montés sur un châssis 3, et reliés au réseau électrique traditionnel 5 par l'intermédiaire d'un onduleur 4. Selon l'invention, ce dispositif comprend un capteur à ultrasons 6 positionné au niveau d'un module photovoltaïque 2, relié par une liaison de communication 7 à une unité de traitement du signal 8 apte à analyser les données transmises par le capteur 6. Cette unité de traitement 8 est elle-même reliée par un moyen de communication 9 à un dispositif de sécurité 10 dont la fonction est d'ouvrir le circuit électrique sur demande de l'unité de traitement 8 en cas d'arc électrique. Ces différents composants du dispositif photovoltaïque sont alimentés en énergie directement par les modules photovoltaïques.

Selon le mode d'exécution de l'invention, le capteur à ultrasons 6 est positionné de manière optimale pour capter les ondes acoustiques du dispositif photovoltaïque. Il peut par exemple se trouver sur le cadre ou sur le verre, dans la boîte de raccordement du module. En variante, il peut aussi être placé sur le châssis 3 supportant les modules 2.

L'unité de traitement 8 a pour fonction d'analyser les données reçues par le capteur à ultrasons 6 et met en oeuvre par des moyens matériel et/ou logiciel, de manière analogique ou numérique, un procédé de détection d'arcs électriques, qui sera détaillé ci-dessous. Ce procédé permet de reconnaître parmi les nombreuses données transmises par le capteur, celles qui correspondent spécifiquement au bruit émis par un arc électrique, en reconnaissant la signature acoustique particulière d'un tel arc électrique. Selon des réalisations possibles, cette unité de traitement 8 peut comprendre plusieurs entrées et sorties, notamment une sortie vers l'onduleur 4, et/ou vers un autre organe de gestion du dispositif photovoltaïque ou de gestion de l'énergie. Elle peut aussi comprendre une unité de calcul, comme un microcontrôleur, et des moyens de mémorisation, pour stocker les données prédéfinies correspondant à un arc électrique.

Le procédé de détection d'arc électrique selon l'invention va maintenant être détaillé.
D'abord, selon une étape préliminaire E0, le procédé ne se met en mode de fonctionnement, c'est-à-dire d'écoute des ultrasons, qu'à partir du moment où le dispositif photovoltaïque dépasse un certain seuil de production, par exemple au moins 10% de sa puissance nominale. En-dessous de ce seuil, le risque d'arc électrique n'existe pas et ne nécessite pas de surveillance.

L'étape essentielle de détection de la signature acoustique de l'arc électrique consiste à comparer les données reçues par le capteur 6 avec la signature acoustique enregistrée d'un arc électrique, représentée en figure 2. Selon l'invention, l'onde correspondant à cette signature acoustique est caractérisée par quelques paramètres particuliers, ces paramètres pouvant prendre des valeurs positionnées dans des plages prédéfinies. Ces paramètres sont :
- l'amplitude du signal, qui est supérieure ou égale à 40 dB ; ce paramètre permet par exemple la mise en oeuvre d'une étape consistant à ne pas prendre en compte tous les bruits d'amplitude inférieure ;
- la durée du signal, qui est comprise entre 15 et 25 µs ;
- la fréquence centrale du signal, qui est comprise entre 200 et 360 kHz ;
- la tension efficace du signal, qui augmente, en général de 11 dB_{EA} jusqu'à environ 25 dB_{EA}. Ce paramètre est secondaire par rapport aux trois précédents et pourra être utilisé en combinaison avec un ou plusieurs des trois paramètres précédents.

Ainsi, le procédé de détection selon l'invention consiste à mesurer tout ou partie de ces paramètres, pour vérifier s'ils se trouvent dans des plages de valeur prédéfinies et mémorisées qui correspondent aux valeurs d'un arc électrique.

Le choix des paramètres à utiliser parmi les trois principaux listés précédemment représente un compromis entre la précision souhaitée pour la reconnaissance des arcs électriques et le temps de calcul recherché. Si tous les paramètres sont considérés, la détection des arcs électriques pourra atteindre un taux d'erreur presque nul, la mise en oeuvre du calcul sera toutefois légèrement plus long, ce qui retardera l'intervention sur le circuit. De même, le choix des plages de valeur prédéfinies pour chacun de ces paramètres représente aussi un compromis entre la recherche de la détection d'un maximum d'arcs électriques tout en éliminant un maximum de situations provenant d'un autre événement, afin d'éviter l'ouverture du circuit alors qu'il n'y a pas d'arc électrique.

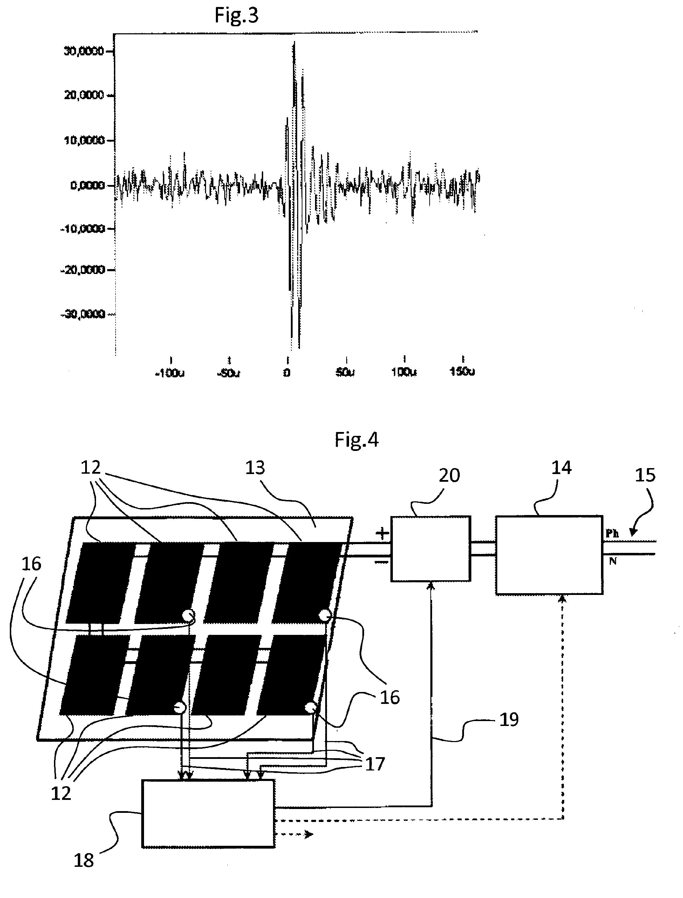

Le procédé de détection mis en oeuvre permet ainsi de reconnaître un arc électrique, avec un taux d'erreur choisi, parmi de nombreux autres événements possibles entraînant aussi la formation d'ondes acoustiques. Cette problématique est très particulière pour une installation photovoltaïque du fait de son environnement extérieur qui génère de nombreux bruits, mais aussi du fait de sa structure qui repose sur le positionnement de ses circuits électriques dans des milieux confinés, dans des matériaux spécifiques, généralement en verre. A titre d'exemple, la dilatation thermique d'un module photovoltaïque génère des bruits sous forme de craquements, qui sont aussi mesurés par le capteur à ultrasons et transmis à l'unité de traitement. La figure 3 illustre l'onde mesurée lors d'un tel événement. La durée de la salve est en général supérieure à 25 µs. De plus, la valeur de la tension efficace du signal enregistré reste constante, n'augmente pas comme dans le cas d'un arc électrique. Les autres bruits principaux rencontrés au niveau d'un module photovoltaïque proviennent de la pluie, qui génère un bruit continu éloigné de l'arc électrique, à l'exception des premières gouttes qui peuvent générer un choc thermique et des phénomènes de dilatation comme mentionnés ci-dessus, du vent qui génère un bruit de fond de faible amplitude, de la grêle qui génère des ondes acoustiques de faible énergie et de fréquence différente de celle d'un arc électrique, des vibrations extérieures, comme suite à un séisme par exemple, de fréquence beaucoup plus basse que celle d'un arc électrique.

Ainsi, le procédé de détection d'un arc électrique selon l'invention va comprendre les deux étapes essentielles suivantes :
E1 - Mesure d'au moins un paramètre d'un signal acoustique reçu par le capteur parmi l'amplitude, la durée de l'onde, la fréquence centrale ;
E2 - Comparaison de la mesure de ce au moins un paramètre avec des valeurs mémorisées pour déterminer si la mesure correspond à celle d'un arc électrique.

La seconde étape E2 comprend plus précisément les vérifications suivantes, qui permettront de considérer que le signal reçu correspond bien à un arc électrique :
- E21 - vérification si l'amplitude est supérieure ou égale à 40 dB ; et/ou
- E22 - vérification si la durée du signal est comprise entre 15 et 25 µs ; et/ou
- E23 - vérification si la fréquence centrale est comprise entre 200 et 360 kHz.

Elle peut comprendre en outre l'étape supplémentaire suivante :
- E24 - vérification si la tension efficace du signal électrique enregistrée augmente. Avantageusement, il pourra être vérifié si elle augmente d'une première valeur proche de 11 dB_{EA}, plus généralement comprise entre 5 et 15 dB_{EA}, vers une seconde valeur proche de 25 dB_{EA}, plus généralement comprise entre 15 et 25 dB_{EA}.

Enfin, le dispositif de sécurité 10 peut être soit disposé sur une des bornes à la sortie du champ photovoltaïque, soit comprendre un dispositif pour chaque module photovoltaïque, par exemple dans sa boîte de raccordement. Après détection d'un arc électrique, l'unité de traitement 8 transmet l'information et l'ordre d'ouverture du circuit électrique au dispositif de sécurité, ce qui permet de stopper la circulation électrique et d'arrêter l'arc électrique, en supprimant ainsi le risque que représenterait l'entretien de l'arc électrique, notamment le risque d'incendie. Ce dispositif de sécurité peut consister en un simple interrupteur commandé à distance.

L'invention porte aussi sur le procédé de gestion sécurisée d'une installation photovoltaïque, qui met en oeuvre le procédé de détection d'arc électrique détaillé précédemment, puis l'étape E3 consistant à ouvrir le circuit électrique en cas de détection d'un arc électrique, afin d'éteindre l'arc électrique. Le procédé peut en outre mettre en oeuvre les étapes supplémentaires suivantes :
E4 - après ouverture du circuit électrique suite à la détection d'un arc électrique, remise en fonctionnement du dispositif photovoltaïque au moins une fois ;
E5 - s'il y a de nouveau la détection d'un arc électrique, arrêt du fonctionnement et transmission d'information de la défaillance de l'installation. Cette information peut être transmise à un opérateur par l'intermédiaire d'un voyant, ou de toute interface homme-machine appropriée.

La figure 4 illustre un dispositif photovoltaïque selon une variante d'exécution, qui diffère du dispositif décrit précédemment par le fait qu'il comprend huit modules photovoltaïques 12 et quatre capteurs à ultrasons 16. La proportion de un capteur pour deux modules est conservée et avantageuse. Toutefois, toute autre proportion serait aussi envisageable sans sortir du concept de l'invention. Ces différents modules sont montés sur un substrat 13, et reliés électriquement au réseau 15 via un onduleur 14. En remarque, le concept de l'invention est aussi bien adapté à une installation photovoltaïque qui ne serait pas reliée au réseau 15, puisqu'elle repose sur des mesures locales au niveau même des modules photovoltaïques. Les capteurs à ultrasons 16 communiquent par des liaisons 17 avec une unité de traitement 18 qui elle-même communique par une liaison 19 avec un dispositif de sécurité 20. Ces derniers composants sont similaires à ceux décrits précédemment.

Ce dispositif fonctionne de manière similaire à celui décrit précédemment et met en oeuvre le procédé de détection d'arc électrique et de gestion sécurisée de l'installation photovoltaïque qui a été explicité précédemment. Selon une caractéristique intéressante, ce dispositif met en oeuvre une fonction supplémentaire de localisation d'un arc électrique, ce qui est avantageux pour améliorer les opérations de maintenance et d'intervention en cas de défaillance, notamment pour les installations très étendues. Une telle fonction peut ainsi permettre d'augmenter la rentabilité et le taux de disponibilité de l'installation, ce qui est important par exemple pour une centrale de production électrique.

Ainsi, ce dispositif met en oeuvre un procédé de gestion qui comprend l'étape supplémentaire E6 consistant à localiser la provenance de l'arc électrique dans l'installation. Cette étape est avantageusement réalisée à partir de la donnée de l'instant de réception par chaque capteur du signal d'arc électrique, qui dépend du temps de propagation de l'onde depuis son emplacement jusqu'au capteur et donne donc une indication sur sa provenance.

L'étape de localisation E6 pourrait donc se décomposer en sous-étapes suivantes :
E61 - mémorisation du temps t0 de réception de l'onde acoustique d'arc électrique du premier capteur 16 à la recevoir, qui sert de temps de référence pour les autres capteurs ;
E62 - mémorisation des temps ti de réception de l'onde acoustique pour chacun des autres capteurs i et classement de ces capteurs dans l'ordre de réception ;
E63 - détermination en fonction de l'ordre d'arrivée de l'onde acoustique sur chaque capteur 16 du module photovoltaïque 12 de la localisation de l'arc électrique.

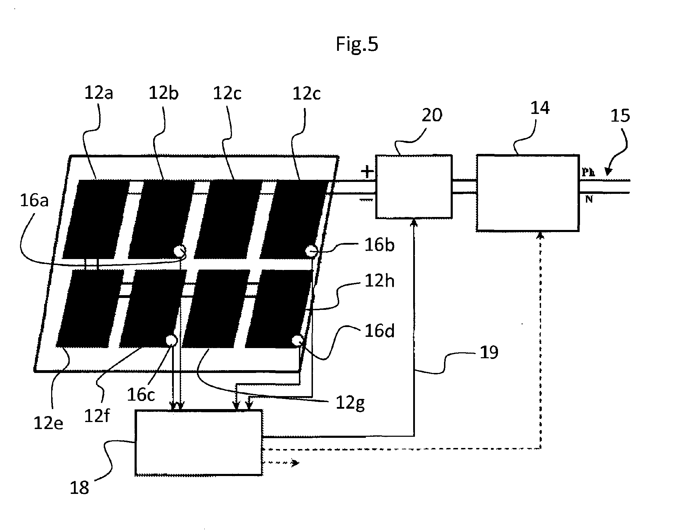

La figure 5 représente un exemple de mise en oeuvre de cette méthode. Les différents modules photovoltaïques de l'installation, qui correspond à celle de la figure 4, ont été référencés de 12a à 12h et les différents capteurs de 16a à 16d. Supposons que le premier capteur recevant l'onde acoustique d'arc électrique soit le capteur référencé 16a, puis que l'onde atteigne dans l'ordre les capteurs 16b, 16c, 16d. Alors l'arc électrique se situe obligatoirement sur le module photovoltaïque 12c.

La méthode de localisation a été donnée à titre d'illustration de l'invention. D'autres procédés sont possibles, tenant compte par exemple des distances exactes entre les différents modules et les capteurs, afin de retrouver en fonction des temps de propagation des signaux leur distance de provenance de chaque capteur, puis leur localisation exacte.

Ensuite, le dispositif pourra mettre en oeuvre une dernière étape E7 de transmission de l'information de localisation, au responsable de l'installation par une interface homme-machine directement positionnée au niveau de l'unité de traitement 18 par exemple, ou par tout autre moyen de communication, par l'intermédiaire de l'onduleur 14 ou d'une centrale de gestion de l'énergie.

Naturellement, le concept de l'invention ne se limite pas aux dispositifs photovoltaïques décrits ci-dessus mais peut être mis en oeuvre dans toute sorte d'installation photovoltaïque, avec de nombreux modules photovoltaïques et d'autres taux de capteurs à ultrasons. Toutefois, l'utilisation d'au moins un capteur pour deux modules photovoltaïques est avantageuse.

L'application de l'invention permet donc bien de répondre aux objets recherchés et présente en outre les avantages suivants :
- comme l'émission d'ultrasons se propage très vite dans le verre (5000 m/s) et atteint le capteur à ultrasons en quelques millisecondes, le dispositif est apte à une coupure du circuit électrique très rapide ;
- la détection des arcs électriques, même au sein des modules, permet ainsi d'éviter une destruction totale d'une installation photovoltaïque par incendie ;
- le dispositif de l'invention fonctionne toujours de manière efficace, même s'il est positionné au voisinage de structures métalliques, sur des bâtiments en béton armé par exemple ;
- cette solution est bien sûr compatible et complémentaire avec d'autres solutions de détection d'arc électrique en dehors des modules photovoltaïques, et peut donc être combinée avec ces autres solutions.

## Revendications

1. Procédé de détection par ultrasons d'un arc électrique dans un dispositif photovoltaïque, **caractérisé en ce qu'**il comprend les étapes suivantes :
- Positionnement d'un capteur à ultrasons (6 ; 16) sur un module photovoltaïque (2 ; 12) ou sur un châssis (3 ; 13) supportant plusieurs modules photovoltaïques (2 ; 12) ;
- Mesure (E1) d'au moins un paramètre d'un signal reçu par le capteur à ultrasons (6 ; 16) parmi l'amplitude du signal, la durée du signal, la fréquence centrale du signal ;
- Comparaison (E2) de la mesure de ce au moins un paramètre du signal avec des valeurs prédéfinies pour déterminer si la mesure correspond à celle d'un arc électrique, cette comparaison comprenant la ou les vérifications suivantes permettant de déterminer que le signal est bien généré par un arc électrique :
- vérification (E21) si l'amplitude du signal reçu est supérieure ou égale à 40 dB ; et/ou
- vérification (E22) si la durée du signal reçu est comprise entre 15 et 25 µs ; et/ou
- vérification (E23) si la fréquence centrale du signal reçu est comprise entre 200 et 360 kHz.

2. Procédé de détection par ultrasons d'un arc électrique selon la revendication précédente, **caractérisé en ce qu'**il comprend en outre l'étape supplémentaire suivante permettant de déterminer que le signal est bien généré par un arc électrique :
- vérification (E24) si la tension efficace du signal enregistré augmente, d'une première valeur comprise entre 5 et 15 dB_{EA}, vers une seconde valeur comprise entre 15 et 25 dB_{EA}.

3. Procédé de gestion sécurisée d'un dispositif photovoltaïque, **caractérisé en ce qu'**il comprend un procédé de détection par ultrasons d'un arc électrique selon l'une des revendications précédentes, puis **en ce qu'**il comprend une étape (E3) consistant à ouvrir le circuit électrique du dispositif photovoltaïque en cas de détection d'un arc électrique, afin d'éteindre l'arc électrique.

4. Procédé de gestion sécurisée d'un dispositif photovoltaïque selon la revendication précédente, **caractérisé en ce qu'**il met en oeuvre les étapes supplémentaires suivantes :
- après ouverture du circuit électrique suite à la détection d'un arc électrique, remise en fonctionnement du dispositif photovoltaïque au moins une fois (E4) ;
- s'il y a de nouveau la détection d'un arc électrique, arrêt du fonctionnement du dispositif photovoltaïque et transmission d'information de la défaillance du dispositif photovoltaïque (E5).

5. Procédé de gestion sécurisée d'un dispositif photovoltaïque selon l'une des revendications 3 ou 4, **caractérisé en ce qu'**il comprend une étape supplémentaire de localisation (E6) de l'arc électrique dans le dispositif photovoltaïque.

6. Procédé de gestion sécurisée d'un dispositif photovoltaïque selon la revendication précédente, **caractérisé en ce que** l'étape de localisation (E6) de l'arc électrique dans le dispositif photovoltaïque comprend les sous-étapes suivantes :
- mémorisation des temps (ti) de réception du signal pour chacun des capteurs (16i) et classement de ces capteurs dans l'ordre de réception (E61, E62);
- détermination en fonction de l'ordre d'arrivée du signal sur chaque capteur (16i) de la localisation (E63) de l'arc électrique.

7. Procédé de gestion sécurisée d'un dispositif photovoltaïque selon l'une des revendications 3 à 6, **caractérisé en ce qu'**il comprend une étape préliminaire (E0) de déclenchement du procédé de détection d'arc électrique qu'à partir du moment où le dispositif photovoltaïque dépasse un certain seuil de production électrique.

8. Dispositif photovoltaïque comprenant des modules photovoltaïques (2 ; 12) montés sur un ou plusieurs châssis (3 ; 13), **caractérisé en ce qu'**il comprend au moins un capteur à ultrasons (6 ; 16) pour la détection des arcs électriques positionné sur un module photovoltaïque (2 ; 12) ou sur un châssis (3 ; 13) supportant plusieurs modules photovoltaïques (2 ; 12) et **en ce qu'**il comprend une unité de traitement (8 ; 18) mettant en oeuvre le procédé de détection des arcs électriques selon l'une des revendications 1 ou 2.

9. Dispositif photovoltaïque selon la revendication précédente, **caractérisé en ce qu'**il comprend au moins un capteur à ultrasons (6 ; 16) pour deux modules photovoltaïques (2 ; 12).

10. Dispositif photovoltaïque selon la revendication 8 ou 9, **caractérisé en ce qu'**il comprend un module photovoltaïque comprenant un capteur à ultrasons (6 ; 16) pour la détection des arcs électriques positionné sur le cadre ou sur le verre du module photovoltaïque et un moyen de communication de ce capteur à ultrasons vers une unité de traitement (8 ; 18).

11. Dispositif photovoltaïque selon l'une des revendications 8 à 10, **caractérisé en ce qu'**il comprend un dispositif de sécurité (10 ; 20) dont la fonction est d'ouvrir le circuit électrique en cas de détection d'arc électrique, le dispositif photovoltaïque mettant en oeuvre le procédé de gestion sécurisée selon l'une des revendications 3 à 7.

12. Dispositif photovoltaïque selon la revendication précédente, **caractérisé en ce que** le dispositif de sécurité (10 ; 20) est positionné sur une borne de sortie du champ de modules photovoltaïques (2 ; 12) du dispositif photovoltaïque ou directement au niveau de tout ou partie des modules photovoltaïques (2 ; 12).

## Patentansprüche

1. Verfahren zur Ultraschallerfassung eines Lichtbogens in einer Photovoltaikvorrichtung, **dadurch gekennzeichnet, dass** es die folgenden Schritte enthält:
- Positionierung eines Ultraschallsensors (6; 16) auf einem Photovoltaikmodul (2; 12) oder auf einer mehrere Photovoltaikmodule (2; 12) tragenden Grundplatte (3; 13);
- Messung (E1) mindestens eines Parameters eines vom Ultraschallsensor (6; 16) empfangenen Signals unter der Amplitude des Signals, der Dauer des Signals, der Mittenfrequenz dieses Signals;
- Vergleich (E2) des Messwerts dieses mindestens einen Parameters des Signals mit vordefinierten Werten, um festzustellen, ob der Messwert demjenigen eines Lichtbogens entspricht, wobei dieser Vergleich die folgende(n) Verifizierung(en) enthält, die es ermöglichen festzustellen, ob das Signal wirklich von einem Lichtbogen erzeugt wird:
- Verifizierung (E21), ob die Amplitude des empfangenen Signals höher als oder gleich 40 dB ist; und/oder
- Verifizierung (E22), ob die Dauer des empfangenen Signals zwischen 15 und 25 µs liegt; und/oder
- Verifizierung (E23), ob die Mittenfrequenz des empfangenen Signals zwischen 200 und 360 kHz liegt.

2. Verfahren zur Ultraschallerfassung eines Lichtbogens nach dem vorhergehenden Anspruch, **dadurch gekennzeichnet, dass** es außerdem den folgenden zusätzlichen Schritt enthält, der es ermöglicht festzustellen, ob das Signal tatsächlich von einem Lichtbogen erzeugt wird:
- Verifizierung (E24), ob die Effektivspannung des gespeicherten Signals von einem ersten Wert zwischen 5 und 15 dB_{EA} bis zu einem zweiten Wert zwischen 15 und 25 dB_{EA} zunimmt.

3. Verfahren zur gesicherten Verwaltung einer Photovoltaikvorrichtung, **dadurch gekennzeichnet, dass** es ein Verfahren zur Ultraschallerfassung eines Lichtbogens nach einem der vorhergehenden Ansprüche enthält, dass es dann einen Schritt (E3) enthält, der darin besteht, den Stromkreis der Photovoltaikvorrichtung im Fall der Erfassung eines Lichtbogens zu öffnen, um den Lichtbogen zu löschen.

4. Verfahren zur gesicherten Verwaltung einer Photovoltaikvorrichtung nach dem vorhergehenden Anspruch, **dadurch gekennzeichnet, dass** es die folgenden zusätzlichen Schritte anwendet:
- nach dem Öffnen des Stromkreises aufgrund der Erfassung eines Lichtbogens, mindestens eine Wiederinbetriebnahme (E4) der Photovoltaikvorrichtung;
- wenn erneut ein Lichtbogen erfasst wird, Anhalten des Betriebs der Photovoltaikvorrichtung und Informationsübertragung des Ausfalls der Photovoltaikvorrichtung (E5).

5. Verfahren zur gesicherten Verwaltung einer Photovoltaikvorrichtung nach einem der Ansprüche 3 oder 4, **dadurch gekennzeichnet, dass** es einen zusätzlichen Schritt der Lokalisierung (E6) des Lichtbogens in der Photovoltaikvorrichtung enthält.

6. Verfahren zur gesicherten Verwaltung einer Photovoltaikvorrichtung nach dem vorhergehenden Anspruch, **dadurch gekennzeichnet, dass** der Schritt der Lokalisierung (E6) des Lichtbogens in der Photovoltaikvorrichtung die folgenden Teilschritte enthält:
- Speichern der Empfangszeiten (ti) des Signals für jeden der Sensoren (16i) und Einordnen dieser Sensoren in der Empfangsreihenfolge (E61, E62);
- Feststellen der Lokalisierung (E63) des Lichtbogens abhängig von der Ankunftsreihenfolge des Signals an jedem Sensor (16i).

7. Verfahren zur gesicherten Verwaltung einer Photovoltaikvorrichtung nach einem der Ansprüche 3 bis 6, **dadurch gekennzeichnet, dass** es einen einleitenden Schritt (E0) des Auslösens des Lichtbogenerfassungsverfahrens erst ab dem Moment enthält, in dem die Photovoltaikvorrichtung eine gewisse Schwelle der Stromerzeugung überschreitet.

8. Photovoltaikvorrichtung, die Photovoltaikmodule (2; 12) enthält, die auf eine oder mehrere Grundplatten (3; 13) montiert sind, **dadurch gekennzeichnet, dass** sie mindestens einen Ultraschallsensor (6; 16) zur Erfassung der Lichtbögen enthält, der auf einem Photovoltaikmodul (2; 12) oder auf einer mehrere Photovoltaikmodule (2; 12) tragenden Grundplatte (3; 13) positioniert ist, und dass sie eine Verarbeitungseinheit (8; 18) enthält, die das Verfahren zur Erfassung der Lichtbögen nach einem der Ansprüche 1 oder 2 anwendet.

9. Photovoltaikvorrichtung nach dem vorhergehenden Anspruch, **dadurch gekennzeichnet, dass** sie mindestens einen Ultraschallsensor (6; 16) für zwei Photovoltaikmodule (2; 12) enthält.

10. Photovoltaikvorrichtung nach Anspruch 8 oder 9, **dadurch gekennzeichnet, dass** sie ein Photovoltaikmodul enthält, das einen Ultraschallsensor (6; 16) zur Erfassung der Lichtbögen, der auf dem Rahmen oder dem Glas des Photovoltaikmoduls positioniert ist, und eine Verbindungseinrichtung dieses Ultraschallsensors mit einer Verarbeitungseinheit (8; 18) enthält.

11. Photovoltaikvorrichtung nach einem der Ansprüche 8 bis 10, **dadurch gekennzeichnet, dass** sie eine Sicherheitsvorrichtung (10; 20) enthält, deren Funktion es ist, den Stromkreis im Fall der Erfassung eines Lichtbogens zu öffnen, wobei die Photovoltaikvorrichtung das Verfahren der gesicherten Verwaltung nach einem der Ansprüche 3 bis 7 anwendet.

12. Photovoltaikvorrichtung nach dem vorhergehenden Anspruch, **dadurch gekennzeichnet, dass** die Sicherheitsvorrichtung (10; 20) auf einer Ausgangsklemme des Felds von Photovoltaikmodulen (2; 12) der Photovoltaikvorrichtung oder direkt im Bereich aller oder eines Teils der Photovoltaikmodule (2; 12) positioniert ist.

## Claims

1. Method for detecting an electric arc in a photovoltaic device by ultrasound, **characterized in that** it comprises the following steps:
- positioning an ultrasound sensor (6; 16) on a photovoltaic module (2; 12) or on a chassis (3; 13) supporting a plurality of photovoltaic modules (2; 12);
- measuring (E1) at least one parameter among the amplitude of the signal, the duration of the signal and the central frequency of the signal, of a signal received by an ultrasound sensor (6; 16);
- comparing (E2) the measurement of this at least one parameter of the signal with predefined values in order to determine whether the measurement corresponds to that of an electric arc,
this comparison comprising the following check(s) for determining whether the signal is actually generated by an electric arc:
- checking (E21) whether the amplitude of the received signal is greater than or equal to 40 dB;
and/or
- checking (E22) whether the duration of the received signal lies between 15 and 25 µs; and/or
- checking (E23) whether the central frequency of the received signal lies between 200 and 360 kHz.

2. Method for detecting an electric arc by ultrasound according to the preceding claim, **characterized in that** it furthermore comprises the following additional step for determining whether the signal is actually generated by an electric arc:
- checking (E24) whether the rms voltage of the recorded signal increases from a first value of between 5 and 15 dB_{EA} to a second value of between 15 and 25 dB_{EA}.

3. Method for safeguarded management of a photovoltaic device, **characterized in that** it comprises a method for detecting an electric arc by ultrasound according to either of the preceding claims, then **in that** it comprises a step (E3) consisting in opening the electrical circuit of the photovoltaic device in the event that an electric arc is detected, in order to extinguish the electric arc.

4. Method for safeguarded management of a photovoltaic device according to the preceding claim, **characterized in that** it implements the following additional steps:
- after opening the electrical circuit following the detection of an electric arc, putting the photovoltaic device back into operation at least once (E4);
- if an electric arc is detected again, stopping operation of the photovoltaic device and transmitting information about the malfunction of the photovoltaic device (E5).

5. Method for safeguarded management of a photovoltaic device according to either of Claims 3 and 4, **characterized in that** it comprises an additional step (E6) of locating the electric arc in the photovoltaic device.

6. Method for safeguarded management of a photovoltaic device according to the preceding claim, **characterized in that** the step (E6) of locating the electric arc in the photovoltaic device comprises the following substeps:
- storing the signal reception times (ti) for each of the sensors (16i) and ranking these sensors in order of reception (E61, E62);
- determining the location of the electric arc as a function of the order of arrival of the signal at each sensor (16i) (E63).

7. Method for safeguarded management of a photovoltaic device according to one of Claims 3 to 6, **characterized in that** it comprises a preliminary step (E0) of initiating the electric arc detection method only after the time when the photovoltaic device exceeds a certain electrical production threshold.

8. Photovoltaic device comprising photovoltaic modules (2; 12) mounted on one or more chassis (3; 13), **characterized in that** it comprises at least one ultrasound sensor (6; 16) for the detection of electric arcs, positioned on a photovoltaic module (2; 12) or on a chassis (3; 13) supporting a plurality of photovoltaic modules (2; 12), and **in that** it comprises a processing unit (8; 18) carrying out the electric arc detection method according to either of Claims 1 and 2.

9. Photovoltaic device according to the preceding claim, **characterized in that** it comprises at least one ultrasound sensor (6; 16) per two photovoltaic modules (2; 12).

10. Photovoltaic device according to Claim 8 or 9, **characterized in that** it comprises a photovoltaic module comprising an ultrasound sensor (6; 16) for the detection of electric arcs, which is positioned on the frame or on the glass of the photovoltaic module, and a means of communication from this ultrasound sensor to a processing unit (8; 18).

11. Photovoltaic device according to one of Claims 8 to 10, **characterized in that** it comprises a safety device (10; 20), the function of which is to open the electrical circuit in the event that an electric arc is detected, the photovoltaic device carrying out the safeguarded management method according to one of Claims 3 to 7.

12. Photovoltaic device according to the preceding claim, **characterized in that** the safety device (10; 20) is positioned on an output terminal of the array of photovoltaic modules (2; 12) of the photovoltaic device or directly at all or some of the photovoltaic modules (2; 12).
